# EUROPEAN PATENT APPLICATION

(11) **EP 3 961 679 A1**
(43) Date of publication of application: **02.03.2022**
(21) Application number: 21170362.4
(22) Date of filing: 26.04.2021
(51) Int. Cl.: H01L 21/48, H01L 23/498

(54) **SURFACE FINISH STRUCTURE OF MULTI-LAYER SUBSTRATE AND METHOD FOR MANUFACTURING THE SAME**

(30) Priority: 28.08.2020 TW 109129659
(71) Applicant: Princo Corp., Hsinchu City 30077 (TW)
(72) Inventor: Chiu, Pei-liang, 30077 Hsinchu City (TW)
(74) Representative: Petraz, Gilberto Luigi

(57) **Abstract**

A surface finish structure (30) of a multi-layer substrate includes: a dielectric layer (300); at least one pad layer (302) formed on the dielectric layer (300); at least one protective metal layer (304) formed on the at least one pad layer (302) and contacting the pad layer (302), wherein the at least one protective metal layer (304) only covers a top surface of the at least one pad layer (302), and the at least one protective metal layer (304) is configured to be soldered to or contact an external element; and a solder mask layer (306) formed on the dielectric layer (300) and including at least one opening (308) to expose the at least one protective metal layer (304). A method for manufacturing a surface finish structure of a multi-layer substrate is also provided.

## Description

### TECHNICAL FIELD OF DISCLOSURE

The present disclosure relates to the technical field of multi-layer substrates, and more particularly to a surface finish structure of a multi-layer substrate and a method for manufacturing the same.

### BACKGROUND OF DISCLOSURE

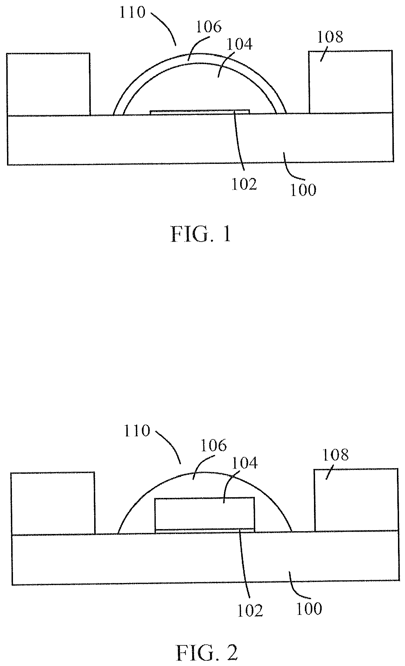

Please refer to FIG. 1. FIG. 1 illustrates a conventional surface finish structure of a multi-layer substrate.

The surface finish structure of the multi-layer substrate includes a dielectric layer 100, an electrically conductive seed layer 102, a pad layer 104, a protective metal layer 106, and a solder mask layer 108.

When the surface finish structure of the multi-layer substrate is manufactured, a groove 110 is formed on the dielectric layer 100 by a photoresist layer (not shown). Then, the electrically conductive seed layer 102 is formed on a bottom of the groove 110 by a sputtering method or an evaporation method and contacts the dielectric layer 100. The electrically conductive seed layer 102 is served as a seed of the pad layer 104. Then, the photoresist layer is removed. The pad layer 104 grows up upwardly and laterally based on the center of the electrically conductive seed layer 102 by an electroplating method or an electroless plating method. The protective metal layer 106 is formed, by an electroplating method or a chemical plating method, on the pad layer 104 to cover the pad layer 104 totally. Finally, the solder mask layer 108 is formed to expose the protective metal layer 106 partially or totally.

When an external element requires to be soldered on the pad layer 104 made of copper material, tin material or a solder flux is used for adhering the external element to the pad layer 104. An objective of the protective metal layer 106 is to avoid a situation that the tin material or the solder flux and the copper of the pad layer 104 are melted mutually to form an intermetallic compound (IMC) when the tin material or the solder flux contacts the copper of the pad layer 104. In this situation, the surface finish structure of the multi-layer substrate is fragile, and product reliability is lowered.

Please refer to FIG. 2. FIG. 2 illustrates another conventional surface finish structure of a multi-layer substrate.

A difference between the surface finish structure of the multi-layer substrate in FIG. 2 and the surface finish structure of the multi-layer substrate in FIG. 1 is that the photoresist layer (not shown) is not removed in FIG. 2 after the electrically conductive seed layer 102 is formed. The photoresist layer (not shown) is removed after the pad layer 104 is formed by an electroplating method or a chemical plating method.

In the surface finish structures of the multi-layer substrates in FIG. 1 and FIG. 2, the solder mask layer 108 can be formed first. The groove 110 is formed in the solder mask layer 108. The electrically conductive seed layer 102, the pad layer 104, and the protective metal layer 106 are formed in the groove 110. Alternatively, the pad layer 104 and the protective metal layer 106 can be formed first, and then the solder mask layer 108 is formed. The groove 110 is formed to expose the protective metal layer 106.

However, when the pad layer 104 and the protective metal layer 106 are formed by the electroplating method or the chemical plating method, the pad layer 104 and the protective metal layer 106 expand from lateral sides of the electrically conductive seed layer 102. Accordingly, the pad layer 104 and the protective metal layer 106 are widened. As shown in FIG. 1, generally speaking, when a thickness of the pad layer 104 is 10 micrometers (µm), a width of one side of the pad layer 104 which externally expands from one side of the electrically conductive seed layer 102 is ranged from 2µm to 4µm. That is, a width of the whole (two sides) of the pad layer 104 which externally expands from two sides of the electrically conductive seed layer 102 is ranged from 4µm to 8µm. A width of the whole (two sides) of the protective metal layer 106 which externally expands from the two sides of the electrically conductive seed layer 102 is ranged from 6µm to 10µm.

In the surface finish structure of the multi-layer substrate in FIG. 2, a width of the whole (two sides) of the protective metal layer 106 which externally expands from the two sides of the electrically conductive seed layer 102 is also ranged from 6µm to 10µm.

Furthermore, the processes of forming the pad layer 104 and the protective metal layer 106 by the electroplating method or the chemical plating method are made in solutions. Many factors, for example, concentration, temperature, material and so on, affect the ranges of the pad layer 104 and the protective metal layer 106 which externally expand from the electrically conductive seed layer 102. As such, it is difficult to control the size of the pad layer 104 and the protective metal layer 106.

Furthermore, due to miniaturization of line pitches in integrated circuits, a horizontal pad pitch between two adjacent pad layers is getting smaller and smaller to meet the fast speed of miniaturization of integrated circuits of wafers. The horizontal pad pitch with the speed of miniaturization was approximately equal to 10 nanometers (nm) four years ago, and it is 5 nm nowadays. In 2026, the horizontal pad pitch with the speed of miniaturization will be expected to advance to 2nm even Inm. To meet miniaturization of wafers, a distance between two adjacent electrical connection points of a bare die will be expected to be smaller than 30µm five years later from 80µm-100µm nowadays. When a pad pitch between two adjacent pad layers (configured to be electrically connected to electrical connection points of a bare die) is smaller than 30µm, a width of each pad layer is smaller than 18µm. Unexpected expansion in the electroplating method and the chemical plating method will become a barrier of fining the pad layer 104 and the protective metal layer 106 in FIG. 1 and FIG. 2.

Therefore, there is a need to solve the above-mentioned problems in the prior art.

### SUMMARY OF DISCLOSURE

An objective of the present disclosure is to provide a surface finish structure of a multi-layer substrate and a method for manufacturing the same capable of solving the problems in the prior art.

The surface finish structure of the multi-layer substrate of the present disclosure includes: a dielectric layer; at least one pad layer formed on the dielectric layer; at least one protective metal layer formed on the at least one pad layer and contacting the at least one pad layer, wherein the at least one protective metal layer only covers a top surface of the at least one pad layer, and the at least one protective metal layer is configured to be soldered to or contact an external element; and a solder mask layer formed on the dielectric layer and including at least one opening to expose the at least one protective metal layer.

The surface finish structure of the multi-layer substrate of the present disclosure includes: a dielectric layer; at least one pad layer embedded in the dielectric layer; and at least one protective metal layer formed on the at least one pad layer and contacting the at least one pad layer, wherein the at least one protective metal layer only covers a top surface of the at least one pad layer, the at least one protective metal layer is configured to be soldered to or contact an external element, and the at least one protective metal layer is also embedded in the dielectric layer.

The method for manufacturing the surface finish structure of the multi-layer substrate of the present disclosure includes: providing a dielectric layer; forming at least one pad layer on the dielectric layer; forming at least one protective metal layer on the at least one pad layer, wherein the at least one protective metal layer only covers a top surface of the at least one pad layer, and the at least one protective metal layer is configured to be soldered to or contact an external element; and forming a solder mask layer on the dielectric layer, wherein the solder mask layer includes at least one opening to expose the at least one protective metal layer.

The method for manufacturing the surface finish structure of the multi-layer substrate of the present disclosure includes: providing a dielectric layer; forming at least one groove in the dielectric layer; forming at least one pad layer in the at least one groove, wherein the at least one pad layer is embedded in the dielectric layer; and forming at least one protective metal layer on the at least one pad layer, wherein the at least one protective metal layer only covers a top surface of the at least one pad layer, the at least one protective metal layer is configured to be soldered to or contact an external element, and the at least one protective metal layer is also embedded in the dielectric layer.

The method for manufacturing the surface finish structure of the multi-layer substrate of the present disclosure includes: providing a substrate; forming a photosensitive dielectric layer on the substrate; patterning the photosensitive dielectric layer to form at least one groove in the photosensitive dielectric layer; forming at least one pad layer in the at least one groove; and forming at least one protective metal layer on the at least one pad layer, wherein the at least one protective metal layer only covers a top surface of the at least one pad layer, and the at least one protective metal layer is configured to be soldered to or contact an external element.

In the surface finish structure of the multi-layer substrate and the method for manufacturing the same of the present disclosure, the protective metal layer only covers the top surface of the pad layer, does not externally expand from two sides of the pad layer, and does not affect the original functions of the pad layer and the protective metal layer. As such, a problem that a pad layer and a protective metal layer cannot be fined due to unexpected expansion in the prior art can be solved.

### BRIEF DESCRIPTION OF DRAWINGS

FIG. 1 illustrates a conventional surface finish structure of a multi-layer substrate.
FIG. 2 illustrates another conventional surface finish structure of a multi-layer substrate.
FIG. 3 illustrates a surface finish structure of a multi-layer substrate in accordance with an embodiment of the present disclosure.
FIG. 4 illustrates a surface finish structure of a multi-layer substrate in accordance with another embodiment of the present disclosure.
FIG. 5 illustrates a surface finish structure of a multi-layer substrate in accordance with yet another embodiment of the present disclosure.
FIG. 6 illustrates a surface finish structure of a multi-layer substrate in accordance with yet another embodiment of the present disclosure.
FIG. 7 illustrates a flow chart of a method for manufacturing a surface finish structure of a multi-layer substrate in accordance with an embodiment of the present disclosure.
FIG. 8A to FIG. 8F illustrate a detailed flow chart of a method for manufacturing a surface finish structure of a multi-layer substrate in accordance with an embodiment of the present disclosure.
FIG. 9A to FIG. 9G illustrate a detailed flow chart of a method for manufacturing a surface finish structure of a multi-layer substrate in accordance with another embodiment of the present disclosure.
FIG. 10A to FIG. 10D illustrate a detailed flow chart of a method for manufacturing a surface finish structure of a multi-layer substrate in accordance with yet another embodiment of the present disclosure.
FIG. 11A to FIG. 11E illustrate a detailed flow chart of a method for manufacturing a surface finish structure of a multi-layer substrate in accordance with yet another embodiment of the present disclosure.
FIG. 12A to FIG. 12G illustrate a detailed flow chart of a method for manufacturing a surface finish structure of a multi-layer substrate in accordance with yet another embodiment of the present disclosure.

### DETAILED DESCRIPTION OF DISCLOSURE

To make the objectives, technical schemes, and technical effects of the present disclosure clearer and more definitely, the present disclosure will be described in detail below by using embodiments in conjunction with the appending drawings. It should be understood that the specific embodiments described herein are merely for explaining the present disclosure, and as used herein, the term "embodiment" refers to an instance, an example, or an illustration but is not intended to limit the present disclosure. In addition, the articles "a" and "an" as used in the specification and the appended claims should generally be construed to mean "one or more" unless specified otherwise or clear from the context to be directed to a singular form. Also, in the appending drawings, the components having similar or the same structure or function are indicated by the same reference number.

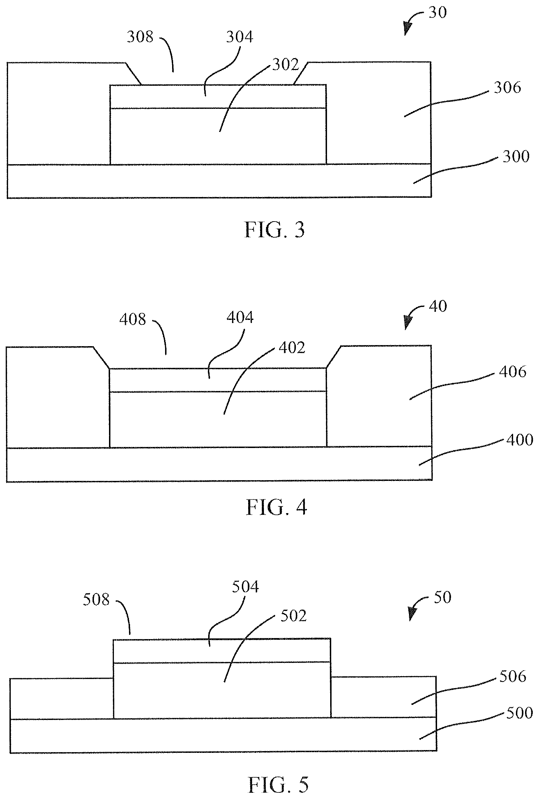

Please refer to FIG. 3. FIG. 3 illustrates a surface finish structure 30 of a multi-layer substrate in accordance with an embodiment of the present disclosure.

The surface finish structure 30 of the multi-layer substrate includes a dielectric layer 300, at least one pad layer (one pad layer 302 is included in the present embodiment), at least one protective metal layer (one protective metal layer 304 is included in the present embodiment), and a solder mask layer 306.

A material of the dielectric layer 300 is polyimide (PI).

The pad layer 302 is formed on the dielectric layer 300. A material of the pad layer 302 is copper.

The protective metal layer 304 is formed on the pad layer 302 and contacts the pad layer 302. The protective metal layer 304 mainly only covers a top surface of the pad layer 302. The protective metal layer 304 is configured to be soldered to or contact an external element. In detail, the protective metal layer 304 does not externally expand from two sides of the pad layer 302 and does not affect original functions of the pad layer 302 and the protective metal layer 304. A material of the protective metal layer 304 is selected from the group consisting of chromium, nickel, palladium, and gold.

The solder mask layer 306 is formed on the dielectric layer 300 and includes at least one opening (one opening 308 is included in the present embodiment) to expose the protective metal layer 304. In the present embodiment, the solder mask layer 306 covers a portion of a top surface of the protective metal layer 304 and exposes a remaining portion of the top surface of the protective metal layer 304. Since the solder mask layer 306 covers the portion of the top surface of the protective metal layer 304, an area of a bottom surface of the opening 308 is smaller than an area of the protective metal layer 304. The area of the protective metal layer 304 refers to an area of the top surface of the protective metal layer 304 or an area of a bottom surface of the protective metal layer 304. The area of the top surface of the protective metal layer 304 is equal to the area of the bottom surface of the protective metal layer 304.

Please refer to FIG. 4. FIG. 4 illustrates a surface finish structure 40 of a multi-layer substrate in accordance with another embodiment of the present disclosure.

The surface finish structure 40 of the multi-layer substrate includes a dielectric layer 400, at least one pad layer (one pad layer 402 is included in the present embodiment), at least one protective metal layer (one protective metal layer 404 is included in the present embodiment), and a solder mask layer 406.

A material of the dielectric layer 400 is polyimide (PI).

The pad layer 402 is formed on the dielectric layer 400. A material of the pad layer 402 is copper.

The protective metal layer 404 is formed on the pad layer 402 and contacts the pad layer 402. The protective metal layer 404 mainly only covers a top surface of the pad layer 402. The protective metal layer 404 is configured to be soldered to or contact an external element. In detail, the protective metal layer 404 does not externally expand from two sides of the pad layer 402 and does not affect original functions of the pad layer 402 and the protective metal layer 404. A material of the protective metal layer 404 is selected from the group consisting of chromium, nickel, palladium, and gold.

The solder mask layer 406 is formed on the dielectric layer 400 and includes at least one opening (one opening 408 is included in the present embodiment) to expose a top surface of the protective metal layer 404. In the present embodiment, an area of a bottom surface of the opening 408 is equal to an area of the protective metal layer 404. That is, two sides of the pad layer 402 and two sides of the protective metal layer 404 contact the solder mask layer 406. The area of the protective metal layer 404 refers to an area of the top surface of the protective metal layer 404 or an area of a bottom surface of the protective metal layer 404. The area of the top surface of the protective metal layer 404 is equal to the area of the bottom surface of the protective metal layer 404. In another embodiment, the area of the bottom surface of the opening 408 can be greater than the area of the bottom surface of the protective metal layer 404. A top surface of the solder mask layer 406 is higher than the top surface of the protective metal layer 404.

Please refer to FIG. 5. FIG. 5 illustrates a surface finish structure 50 of a multi-layer substrate in accordance with yet another embodiment of the present disclosure.

The surface finish structure 50 of the multi-layer substrate includes a dielectric layer 500, at least one pad layer (one pad layer 502 is included in the present embodiment), at least one protective metal layer (one protective metal layer 504 is included in the present embodiment), and a solder mask layer 506.

A material of the dielectric layer 500 is polyimide (PI).

The pad layer 502 is formed on the dielectric layer 500. A material of the pad layer 502 is copper.

The protective metal layer 504 is formed on the pad layer 502 and contacts the pad layer 502. The protective metal layer 504 mainly only covers a top surface of the pad layer 502. The protective metal layer 504 is configured to be soldered to or contact an external element. In detail, the protective metal layer 504 does not externally expand from two sides of the pad layer 502 and does not affect original functions of the pad layer 502 and the protective metal layer 504. A material of the protective metal layer 504 is selected from the group consisting of chromium, nickel, palladium, and gold.

The solder mask layer 506 is formed on the dielectric layer 500 and includes at least one opening (one opening 508 is included in the present embodiment) to expose a top surface and two sides of the protective metal layer 504 and to expose portions of two sides of the pad layer 502. In the present embodiment, a top surface of the solder mask layer 506 is lower than the top surface of the pad layer 502. That is, the portions of the two sides of the pad layer 502 contact the solder mask layer 506. In another embodiment, the top surface of the solder mask layer 506 can be lower than the top surface of the protective metal layer 504 and higher than the top surface of the pad layer 502. That is, portions of the two sides of the protective metal layer 504 and the two sides of the pad layer 502 contact the solder mask layer 506.

In another embodiment, the surface finish structure 50 of the multi-layer substrate includes a plurality of pad layer 502 which are stacked from bottom to top. The top surface of the solder mask layer 506 is lower than a top surface of the pad layers 502.

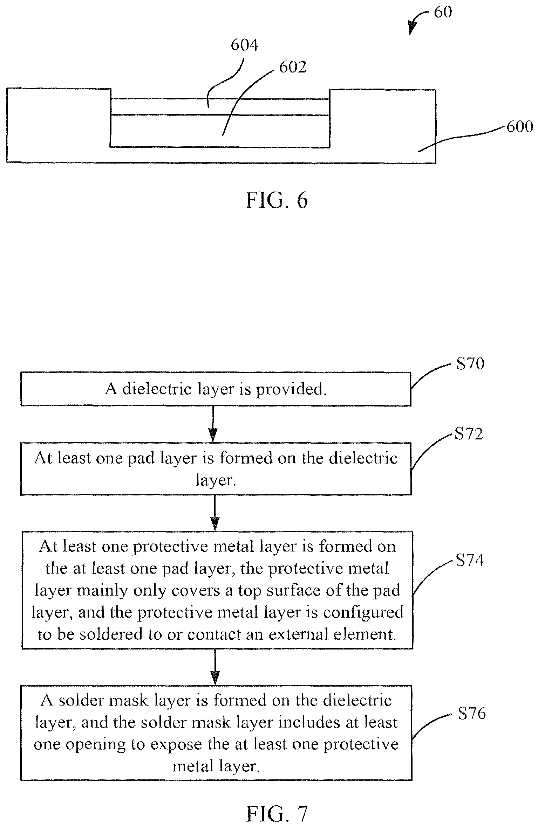

Please refer to FIG. 6. FIG. 6 illustrates a surface finish structure 60 of a multi-layer substrate in accordance with yet another embodiment of the present disclosure.

The surface finish structure 60 of the multi-layer substrate includes a dielectric layer 600, at least one pad layer (one pad layer 602 is included in the present embodiment), and at least one protective metal layer (one protective metal layer 604 is included in the present embodiment).

A material of the dielectric layer 600 is polyimide (PI).

The pad layer 602 is formed and embedded in the dielectric layer 600. A material of the pad layer 602 is copper.

The protective metal layer 604 is formed on the pad layer 602 and contacts the pad layer 602. The protective metal layer 604 mainly only covers a top surface of the pad layer 602. The protective metal layer 604 is configured to be soldered to or contact an external element. In detail, the protective metal layer 604 does not externally expand from two sides of the pad layer 602 and does not affect original functions of the pad layer 602 and the protective metal layer 604. A material of the protective metal layer 604 is selected from the group consisting of chromium, nickel, palladium, and gold. In the present embodiment, the protective metal layer 604 is also embedded in the dielectric layer 600.

Since the pad layer 602 and the protective metal layer 604 are embedded in the dielectric layer 600, the pad layer 602 and the protective metal layer 604 are limited by the dielectric layer 600. That is, the pad layer 602 and the protective metal layer 604 do not externally expand. Two sides of the pad layer 602 and two sides of the protective metal layer 604 contact the dielectric layer 600.

Please refer to FIG. 7. FIG. 7 illustrates a flow chart of a method for manufacturing a surface finish structure of a multi-layer substrate in accordance with an embodiment of the present disclosure.

In step S70, a dielectric layer is provided.

In step S72, at least one pad layer is formed on the dielectric layer.

In step S74, at least one protective metal layer is formed on the at least one pad layer, the protective metal layer mainly only covers a top surface of the pad layer, and the protective metal layer is configured to be soldered to or contact an external element.

In step S76, a solder mask layer is formed on the dielectric layer, and the solder mask layer includes at least one opening to expose the at least one protective metal layer.

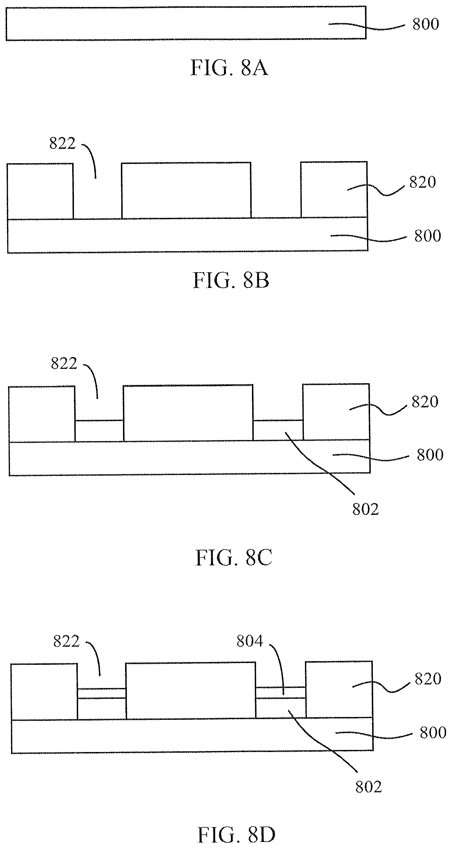

Please refer to FIG. 8A to FIG. 8F. FIG. 8A to FIG. 8F illustrate a detailed flow chart of a method for manufacturing a surface finish structure of a multi-layer substrate in accordance with an embodiment of the present disclosure.

In FIG. 8A, a dielectric layer 800 is provided.

A material of the dielectric layer 800 is polyimide (PI).

In FIG. 8B, a photoresist layer 820 is formed on the dielectric layer 800. The photoresist layer 820 is patterned to form at least one groove 822 in the photoresist layer 820.

The photoresist layer 820 is patterned by an exposure process and a development process.

In FIG. 8C, at least one pad layer (one pad layer 802 is included in the present embodiment) is formed in the at least one groove 822 (on the dielectric layer 800).

Since the pad layer 802 is limited by the least one groove 822 of the photoresist layer 820, the pad layer 802 does not externally expand from two sides of the pad layer 802. As such, a size of the pad layer 802 can be reduced significantly, and a problem that a short circuit occurs between two adjacent points of the pad layer 802 can be avoided. The pad layer 802 can be formed by an electroplating method or a chemical plating method (i.e., an electroless plating method). Alternatively, the pad layer 802 can be formed by a physical vapor deposition (PVD) method. A material of the pad layer 802 is copper.

In FIG 8D, at least one protective metal layer (one protective metal layer 804 is included in the present embodiment) is formed on the pad layer 802. The protective metal layer 804 mainly only covers a top surface of the pad layer 802.

Since the protective metal layer 804 is limited by the least one groove 822 of the photoresist layer 820, the protective metal layer 804 only covers the top surface of the pad layer 802 and does not externally expand from the two sides of the pad layer 802. As such, a size of the protective metal layer 804 can be reduced significantly, and a problem that a short circuit occurs between two adjacent points of the protective metal layer 804 or two adjacent points of the pad layer 802 can be avoided.

The protective metal layer 804 can be formed by an electroplating method or a chemical plating method. Alternatively, the protective metal layer 804 can be formed by a physical vapor deposition (PVD) method. A material of the protective metal layer 804 is selected from the group consisting of chromium, nickel, palladium, and gold.

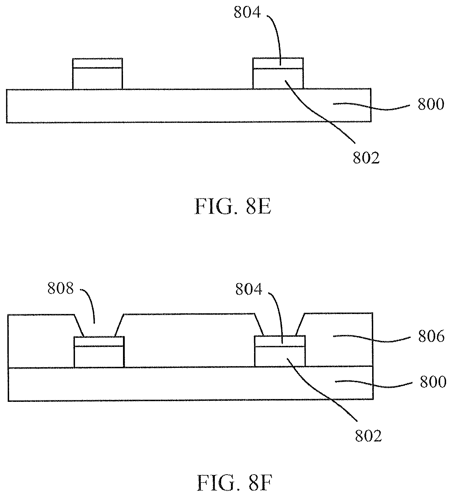

In FIG. 8E, the photoresist layer 820 is removed.

In FIG. 8F, a solder mask layer 806 is formed on the dielectric layer 800. The solder mask layer 806 includes at least one opening 808 to expose the protective metal layer 804.

In the present embodiment, the solder mask layer 806 covers a portion of a top surface of the protective metal layer 804 and exposes a remaining portion of the top surface of the protective metal layer 804. Since the solder mask layer 806 covers the portion of the top surface of the protective metal layer 804, an area of a bottom surface of the opening 808 is smaller than an area of the protective metal layer 804.

In another embodiment, similar to FIG. 4, the area of the bottom surface of the opening 808 can be equal to the area of the protective metal layer 804. The area of the protective metal layer 804 refers to an area of the top surface of the protective metal layer 804 or an area of a bottom surface of the protective metal layer 804. The area of the top surface of the protective metal layer 804 is equal to the area of the bottom surface of the protective metal layer 804. Atop surface of the solder mask layer 806 can be higher than the top surface of the protective metal layer 804. That is, two sides of the pad layer 802 and two sides of the protective metal layer 804 contact the solder mask layer 806.

In yet another embodiment, the area of the bottom surface of the opening 808 can be greater than the area of the protective metal layer 804. The top surface of the solder mask layer 806 can be higher than the top surface of the protective metal layer 804.

In yet another embodiment, similar to FIG. 5, the solder mask layer 806 can be formed on the dielectric layer 800 and include at least one opening 808 to expose the top surface and two sides of the protective metal layer 804 and to expose portions of two sides of the pad layer 802. The top surface of the solder mask layer 806 can be lower than the top surface of the pad layer 802. That is, the portions of the two sides of the pad layer 802 contact the solder mask layer 806. Alternatively, the top surface of the solder mask layer 806 can be lower than the top surface of the protective metal layer 804 and higher than the top surface of the pad layer 802. That is, portions of the two sides of the protective metal layer 804 and the two sides of the pad layer 802 contact the solder mask layer 806.

In one embodiment, after the step in FIG. 8B, the method for manufacturing the surface finish structure of the multi-layer substrate further includes removing a portion or all of the dielectric layer 800 under the groove 822 to form at least one groove (corresponding to a position of the groove 822) in the dielectric layer 800. Then, in the steps in FIG. 8C and FIG. 8D, the pad layer 802 and the protective metal layer 804 are formed in a groove which the dielectric layer 800 and the photoresist layer 820 together form. Alternatively, the pad layer 802 is partially formed in the dielectric layer 800. Alternatively, the protective metal layer 804 is partially formed in the dielectric layer 800. The portion or all of the dielectric layer 800 under the groove 822 can be removed by a laser irradiation method or a reactive ion etching method.

In one embodiment, the step in FIG. 8C includes forming a plurality of pad layers 802. Therein the top surface of the solder mask layer 806 is lower than a top surface of the pad layers 802. The pad layers 802 and the protective metal layer 804 can be served as probes of a wafer testing device. The pad layers 802 are stacked from bottom to top. A first one of the pad layers 802 is formed as shown in FIG. 8C. Then, the photoresist layer 820 is removed as shown in FIG. 8E. A second one of the pad layers 802 is formed and stacked on the first one of the pad layers 802. Then, the photoresist layer 820 is removed as shown in FIG. 8E. The above-mentioned steps are repeated to form the pad layers 802. Finally, the protective metal layer 804 is formed on the stacked pad layers 802.

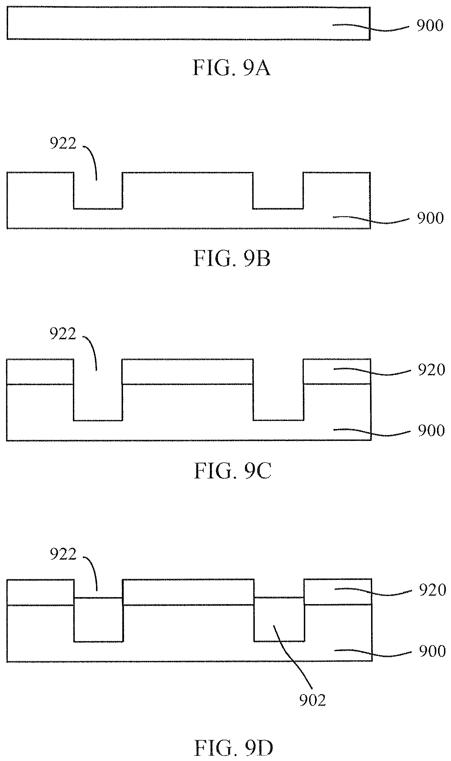

Please refer to FIG. 9A to FIG. 9G. FIG. 9A to FIG. 9G illustrate a detailed flow chart of a method for manufacturing a surface finish structure of a multi-layer substrate in accordance with another embodiment of the present disclosure.

In FIG. 9A, a dielectric layer 900 is provided.

A material of the dielectric layer 900 is polyimide (PI).

In FIG. 9B, at least one groove 922 is formed in the dielectric layer 900. The groove 922 can be formed by a laser irradiation method or a reactive ion etching method.

In FIG. 9C, a photoresist layer 920 is formed on the dielectric layer 900 after the groove 922 is formed. The photoresist layer 920 is patterned. A photoresist on the groove 922 of the dielectric layer 900 is removed.

Processes of patterning the photoresist layer 920 and removing the photoresist on the groove 922 of the dielectric layer 900 include an exposure process and a development process.

In FIG. 9D, at least one pad layer 902 is formed in the groove 922 which the dielectric layer 900 and the photoresist layer 920 together form.

Since the pad layer 902 is limited by the groove 922 which the dielectric layer 900 and the photoresist layer 920 together form, the pad layer 802 does not externally expand from two sides of the pad layer 802. As such, a size of the pad layer 902 can be reduced significantly, and a problem that a short circuit occurs between two adjacent points of the pad layer 902 can be avoided. The pad layer 902 can be formed by an electroplating method or a chemical plating method. Alternatively, the pad layer 902 can be formed by a physical vapor deposition (PVD) method. A material of the pad layer 902 is copper.

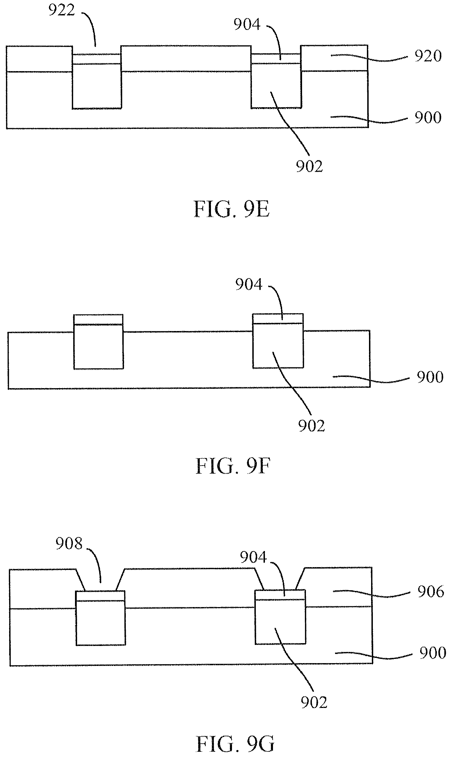

In FIG 9E, at least one protective metal layer 904 is formed on the pad layer 902. The protective metal layer 904 mainly only covers a top surface of the pad layer 902.

Since the protective metal layer 904 is limited by the groove 922 which the dielectric layer 900 and the photoresist layer 920 together form, the protective metal layer 904 does not externally expand from the two sides of the pad layer 902. As such, a size of the protective metal layer 904 can be controlled to be reduced significantly, and a problem that a short circuit occurs between two adjacent points of the protective metal layer 904 or two adjacent points of the pad layers 902 can be avoided.

The protective metal layer 904 can be formed by an electroplating method or a chemical plating method. Alternatively, the protective metal layer 904 can be formed by a physical vapor deposition (PVD) method. A material of the protective metal layer 904 is selected from the group consisting of chromium, nickel, palladium, and gold.

In FIG. 9F, the photoresist layer 920 is removed.

In FIG. 9G, a solder mask layer 906 is formed on the dielectric layer 900. The solder mask layer 906 includes at least one opening 908 to expose the protective metal layer 904.

In the present embodiment, the solder mask layer 906 covers a portion of a top surface of the protective metal layer 904 and exposes a remaining portion of the top surface of the protective metal layer 904. Since the solder mask layer 906 covers the portion of the top surface of the protective metal layer 904, an area of a bottom surface of the opening 908 is smaller than an area of the protective metal layer 904. The area of the protective metal layer 904 refers to an area of the top surface of the protective metal layer 904 or an area of a bottom surface of the protective metal layer 904. The area of the top surface of the protective metal layer 904 is equal to the area of the bottom surface of the protective metal layer 904.

A covering area and a height of the solder mask layer 906 in the present embodiment are the same as those of the embodiment in FIG. 8A to FIG. 8F and can be referred to related descriptions in paragraphs [0065]-[0081].

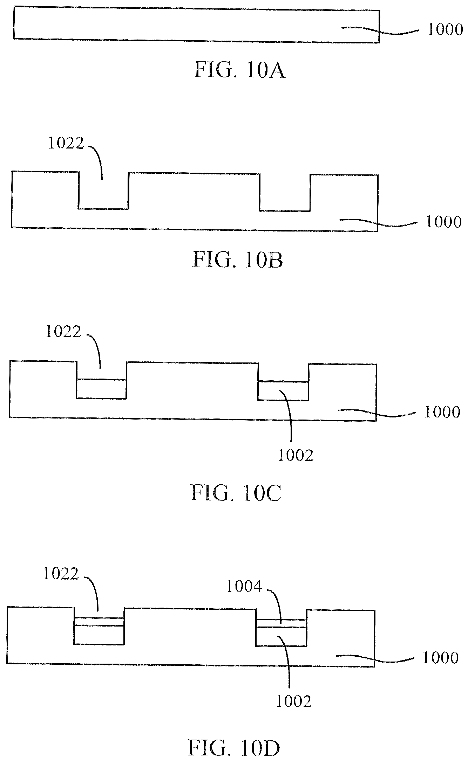

Please refer to FIG. 10A to FIG. 10D. FIG. 10A to FIG. 10D illustrate a detailed flow chart of a method for manufacturing a surface finish structure of a multi-layer substrate in accordance with yet another embodiment of the present disclosure.

In FIG. 10A, a dielectric layer 1000 is provided. A material of the dielectric layer 1000 is polyimide (PI).

In FIG. 10B, at least one groove 1022 is formed in the dielectric layer 1000. The groove 1022 can be formed by a laser irradiation method or a reactive ion etching method.

In FIG. 10C, at least one pad layer 1002 is formed in the groove 1022 of the dielectric layer 1000. The pad layer 1002 is embedded in the dielectric layer 1000. That is, a top surface of the pad layer 1002 is lower than a top surface of the dielectric layer 1000.

The pad layer 1002 can be formed by an electroplating method or a chemical plating method. Alternatively, the pad layer 1002 can be formed by a physical vapor deposition (PVD) method.

It can be appreciated from FIG. 10C that the pad layer 1002 is limited by the groove 1022 when the pad layer 1002 is formed. As such, the pad layer 1002 does not externally expand, and a size of the pad layer 1002 can be controlled. The size of the pad layer 1002 can be minimized. A problem that a short circuit occurs between two adjacent points of the pad layer 1002 can be avoided. A material of the pad layer 1002 is copper.

In FIG 10D, at least one protective metal layer 1004 is formed on the at least one pad layer 1002. The at least one protective metal layer 1004 mainly only covers a top surface of the at least one pad layer 1002. The at least one protective metal layer 1004 is configured to be soldered to or contact an external element. The at least one protective metal layer 1004 is also embedded in the dielectric layer 1000.

The protective metal layer 1004 can be formed by an electroplating method or a chemical plating method. Alternatively, the pad layer 1002 can be formed by a physical vapor deposition (PVD) method.

It can be appreciated from FIG. 10D that the protective metal layer 1004 is embedded in the dielectric layer 100 and thus limited by the groove 1022 when the protective metal layer 1004 is formed. As such, the protective metal layer 1004 does not externally expand, and a size of the protective metal layer 1004 can be controlled. The size of the pad layer 1002 protective metal layer 1004 can be minimized. A problem that a short circuit occurs between two adjacent points of the pad layer 1002 or two adjacent points of the protective metal layer 1004 can be avoided. A material of the protective metal layer 1004 is selected from the group consisting of chromium, nickel, palladium, and gold.

In the present embodiment, a solder mask layer (not shown) can be formed on the dielectric layer 1000 according to requirements after the protective metal layer 1004 is formed. The solder mask layer includes at least one opening to expose the protective metal layer 1004.

A covering area and a height of the solder mask layer in the present embodiment are the same as those of the embodiment in FIG. 8A to FIG. 8F and those of the embodiment in FIG. 9A to FIG. G and are not repeated herein.

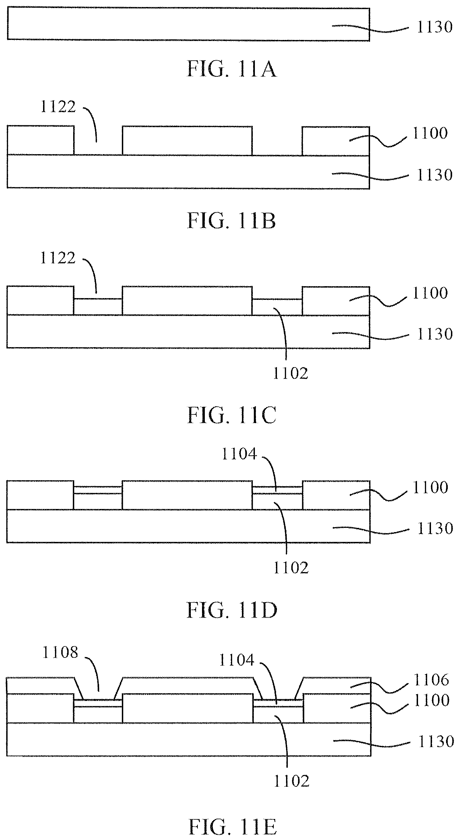

Please refer to FIG. 11A to FIG. 11E. FIG. 11A to FIG. 11E illustrate a detailed flow chart of a method for manufacturing a surface finish structure of a multi-layer substrate in accordance with yet another embodiment of the present disclosure.

In FIG. 11A, a substrate 1130 is provided.

The substrate 1130 can be a single-layer board or a multi-layer board.

In FIG. 11B, a photosensitive dielectric layer 1100 is formed on the substrate 1130. The photosensitive dielectric layer 1100 is patterned to form at least one groove 1122 in the photosensitive dielectric layer 1100.

The photosensitive dielectric layer 1100 is patterned by an exposure process and a development process. Since the exposure process and the development process can be performed on the photosensitive dielectric layer 1100, the photoresist layer 820 in FIG. 8B is not required.

In FIG. 11C, at least one pad layer (one pad layer 1102 is included in the present embodiment) is formed in the at least one groove 1122.

Since the pad layer 1102 is limited by the least one groove 1122 of the photosensitive dielectric layer 1100, the pad layer 1102 does not externally expand from two sides of the pad layer 1102. As such, a size of the pad layer 1102 can be reduced significantly and controlled easily, and a problem that a short circuit occurs between two adjacent points of the pad layer 1102 can be avoided. In the present embodiment, the pad layer 1102 is embedded in the photosensitive dielectric layer 1100. The pad layer 1102 can be formed by an electroplating method or a chemical plating method. Alternatively, the pad layer 1102 can be formed by a physical vapor deposition (PVD) method. A material of the pad layer 1102 is copper.

In FIG. 11D, at least one protective metal layer (one protective metal layer 1104 is included in the present embodiment) is formed on the pad layer 1102. The protective metal layer 1104 mainly only covers a top surface of the pad layer 1102.

Since the protective metal layer 1104 is limited by the groove 1122 of the photosensitive dielectric layer 1100, the protective metal layer 1104 does not externally expand from the two sides of the pad layer 1102. As such, a size of the protective metal layer 1104 can be reduced significantly and controlled easily, and a problem that a short circuit occurs between two adjacent points of the protective metal layer 1104 or two adjacent points of the pad layer 1102 can be avoided. A material of the protective metal layer 1104 is selected from the group consisting of chromium, nickel, palladium, and gold.

In FIG. 11E, a solder mask layer 1106 is formed on the photosensitive dielectric layer 1100. The solder mask layer 1106 includes at least one opening 1108 to expose the protective metal layer 1104.

In the present embodiment, the solder mask layer 1106 covers a portion of a top surface of the protective metal layer 1104 and exposes a remaining portion of the top surface of the protective metal layer 1104. Since the solder mask layer 1106 covers the portion of the top surface of the protective metal layer 1104, an area of a bottom surface of the opening 1108 is smaller than an area of the protective metal layer 1104.

In the present embodiment, the solder mask layer 1106 can be formed according to requirements. An area and a height of the solder mask layer 1106 are the same those of the methods for manufacturing the surface finish structure of the above-mentioned embodiments.

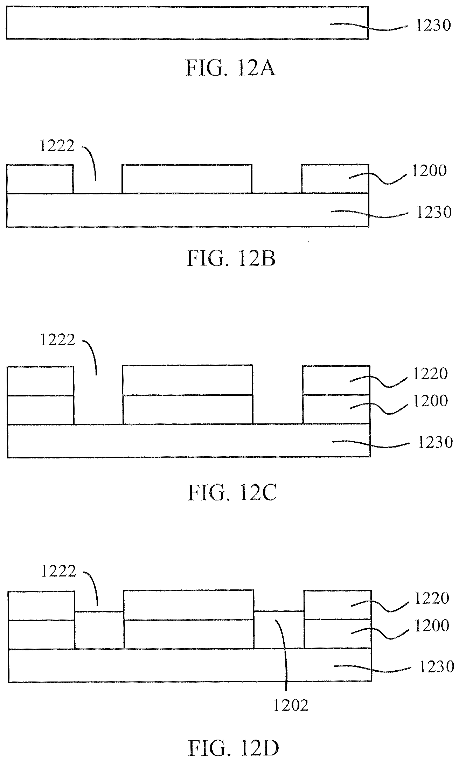

Please refer to FIG. 12A to FIG. 12G. FIG. 12A to FIG. 12G illustrate a detailed flow chart of a method for manufacturing a surface finish structure of a multi-layer substrate in accordance with yet another embodiment of the present disclosure.

In FIG. 12A, a substrate 1230 is provided.

The substrate 1230 can be a single-layer board or a multi-layer board.

In FIG. 12B, a photosensitive dielectric layer 1200 is formed on the substrate 1230. The photosensitive dielectric layer 1200 is patterned to form at least one groove 1222 in the photosensitive dielectric layer 1200. A material of the photosensitive dielectric layer 1200 is polyimide (PI).

The photosensitive dielectric layer 1200 is patterned by an exposure process and a development process. Since the exposure process and the development process can be performed on the photosensitive dielectric layer 1200, the photoresist layer 820 in FIG. 8B is not required.

In FIG. 12C, a photoresist layer 1220 is formed on the patterned photosensitive dielectric layer 1200. The photoresist layer 1220 is patterned. A photoresist on the groove 1222 of the photosensitive dielectric layer 1200 is removed.

The photoresist layer 1220 is patterned by an exposure process and a development process.

In FIG. 12D, at least one pad layer 1202 is formed in the at least one groove 1222.

Since the pad layer 1202 is limited by the least one groove 1222 which the photosensitive dielectric layer 1200 and the photoresist layer 1220 together form, the pad layer 1202 does not externally expand from two sides of the pad layer 1202. As such, a size of the pad layer 1202 can be reduced significantly and controlled easily, and a problem that a short circuit occurs between two adjacent points of the pad layer 1202 can be avoided.

In the present embodiment, the pad layer 1202 is partially embedded in the photosensitive dielectric layer 1200. The pad layer 1202 can be formed by an electroplating method or a chemical plating method. Alternatively, the pad layer 1202 can be formed by a physical vapor deposition (PVD) method. A material of the pad layer 1202 is copper.

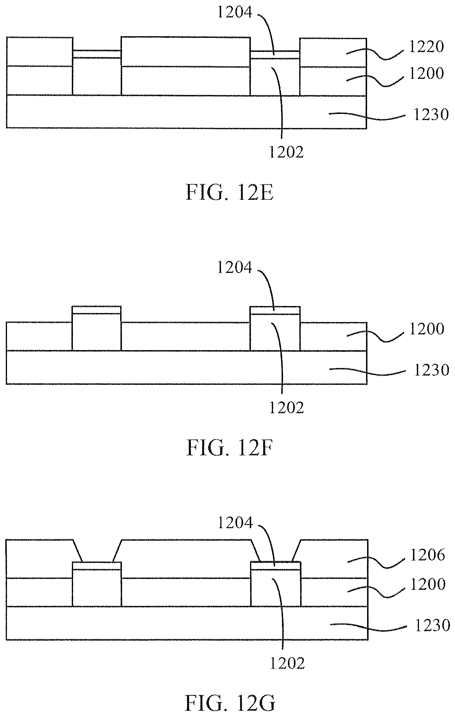

In FIG. 12E, at least one protective metal layer 1204 is formed on the pad layer 1202. The protective metal layer 1204 mainly only covers a top surface of the pad layer 1202.

Since the protective metal layer 1204 is limited by the groove 1222 which the photosensitive dielectric layer 1200 and the photoresist layer 1220 together form, the protective metal layer 1204 does not externally expand from the two sides of the pad layer 1202. As such, a size of the protective metal layer 1204 can be reduced significantly and controlled easily, and a problem that a short circuit occurs between two adjacent points of the protective metal layer 1204 or two adjacent points of the pad layer 1202 can be avoided.

In FIG. 12F, the photoresist layer 1220 is removed.

In FIG. 12G, a solder mask layer 1206 is formed on the photosensitive dielectric layer 1200. The solder mask layer 1206 includes at least one opening 1208 to expose the protective metal layer 1204.

In the present embodiment, an area and a height of the solder mask layer 1206 are the same those of the methods for manufacturing the surface finish structure of the above-mentioned embodiments.

In the surface finish structure of the multi-layer substrate and the method for manufacturing the same, the protective metal layer only covers the top surface of the pad layer and thus does not externally expand from two sides of the pad layer. As such, a problem that a pad layer and a protective metal layer cannot be fined due to unexpected expansion in the prior art can be solved.

## Claims

1. A surface finish structure (30, 40, 50) of a multi-layer substrate, **characterized by** comprising:
a dielectric layer (300, 400, 500);
at least one pad layer (302, 402, 502) formed on the dielectric layer (300, 400, 500);
at least one protective metal layer (304, 404, 504) formed on the at least one pad layer (302, 402, 502) and contacting the at least one pad layer (302, 402, 502), wherein the at least one protective metal layer (304, 404, 504) only covers a top surface of the at least one pad layer (302, 402, 502), and the at least one protective metal layer (304, 404, 504) is configured to be soldered to or contact an external element; and
a solder mask layer (306, 406, 506) formed on the dielectric layer (300, 400, 500) and comprising at least one opening (308, 408, 508) to expose the at least one protective metal layer (304, 404, 504).

2. The surface finish structure (30) according to claim 1, **characterized in that** the solder mask layer (306) covers a portion of a top surface of the at least one protective metal layer (304).

3. The surface finish structure (40) according to claim 1, **characterized in that** an area of the at least one opening (408) is greater than or equal to an area of the at least one protective metal layer (404).

4. The surface finish structure (50) according to claim 1, **characterized in that** a top surface of the solder mask layer (506) is lower than the top surface of the at least one pad layer (502), or the top surface of the solder mask layer (506) is lower than a top surface of the at least one protective metal layer (504) and higher than the top surface of the at least one pad layer (502).

5. The surface finish structure (50) according to claim 1, **characterized by** further comprising a plurality of pad layer (502) which are stacked from bottom to top, wherein a top surface of the solder mask layer (506) is lower than a top surface of the pad layers (502).

6. A surface finish structure (60) of a multi-layer substrate, **characterized by** comprising:
a dielectric layer (600);
at least one pad layer (602) embedded in the dielectric layer (600); and
at least one protective metal layer (604) formed on the at least one pad layer (602) and contacting the at least one pad layer (602), wherein the at least one protective metal layer (604) only covers a top surface of the at least one pad layer (602), the at least one protective metal layer (604) is configured to be soldered to or contact an external element, and the at least one protective metal layer (604) is also embedded in the dielectric layer (600).

7. A method for manufacturing a surface finish structure of a multi-layer substrate, **characterized by** comprising:
providing (S70) a dielectric layer;
forming (S72) at least one pad layer on the dielectric layer;
forming (S74) at least one protective metal layer on the at least one pad layer, wherein the at least one protective metal layer only covers a top surface of the at least one pad layer, and the at least one protective metal layer is configured to be soldered to or contact an external element; and
forming (S76) a solder mask layer on the dielectric layer, wherein the solder mask layer comprises at least one opening to expose the at least one protective metal layer.

8. The method according to claim 7, **characterized in that** the step of forming (S72) the at least one pad layer on the dielectric layer comprises:
forming a photoresist layer on the dielectric layer;
patterning the photoresist layer to form at least one groove in the photoresist layer; and
forming the at least one pad layer in the at least one groove; and
the step of forming (S74) the at least one protective metal layer on the at least one pad layer comprises:
forming the at least one protective metal layer on the at least one pad layer; and
removing the photoresist layer.

9. The method according to claim 8, **characterized in that** after the step of patterning the photoresist layer to form the at least one groove in the photoresist layer, the method further comprises:
removing a portion or all of the dielectric layer under the at least one groove to cause the at least one pad layer to be partially formed in the dielectric layer.

10. The method according to claim 7, **characterized in that** the step of forming (S76) the solder mask layer on the dielectric layer comprises:
forming at least one groove in the dielectric layer;
forming a photoresist layer on the dielectric layer;
patterning the photoresist layer; and removing a photoresist on the at least one groove of the dielectric layer; and
forming at least one pad layer in a groove which the dielectric layer and the photoresist layer together form; and
the step of forming (S74) the at least one protective metal layer on the at least one pad layer comprises:
forming the at least one protective metal layer on the at least one pad layer; and
removing the photoresist layer.

11. The method according to claim 7, **characterized in that** the step of forming (S76) the solder mask layer on the dielectric layer comprises:
forming the solder mask layer on the dielectric layer and the at least one protective metal layer, wherein the solder mask layer covers the dielectric layer and the at least one protective metal layer; and
forming the at least one opening to expose the at least one protective metal layer.

12. The method according to claim 7, **characterized in that** the step of forming (S72) the at least one pad layer on the dielectric layer comprises:
forming a plurality of pad layers on the dielectric layer, wherein the pad layers are stacked from bottom to top, and a top surface of the solder mask layer is lower than a top surface of the pad layers.

13. A method for manufacturing a surface finish structure of a multi-layer substrate, **characterized by** comprising:
providing a dielectric layer (1000);
forming at least one groove (1022) in the dielectric layer (1000);
forming at least one pad layer (1002) in the at least one groove (1022), wherein the at least one pad layer (1002) is embedded in the dielectric layer (1000); and
forming at least one protective metal layer (1004) on the at least one pad layer (1002), wherein the at least one protective metal layer (1004) only covers a top surface of the at least one pad layer (1002), the at least one protective metal layer (1004) is configured to be soldered to or contact an external element, and the at least one protective metal layer (1004) is also embedded in the dielectric layer (1000).

14. A method for manufacturing a surface finish structure of a multi-layer substrate, **characterized by** comprising:
providing a substrate (1130, 1230);
forming a photosensitive dielectric layer (1100, 1200) on the substrate (1130, 1230);
patterning the photosensitive dielectric layer (1100, 1200) to form at least one groove (1122, 1222) in the photosensitive dielectric layer (1100, 1200);
forming at least one pad layer (1102, 1202) in the at least one groove (1122, 1222); and
forming at least one protective metal layer (1104, 1204) on the at least one pad layer (1102, 1202), wherein the at least one protective metal layer (1104, 1204) only covers a top surface of the at least one pad layer (1102, 1202), and the at least one protective metal layer (1104, 1204) is configured to be soldered to or contact an external element.

15. The method according to claim 14, wherein after the step of patterning the photosensitive dielectric layer (1200) to form the at least one groove (1222) in the photosensitive dielectric layer (1200), the method further comprises:
forming a photoresist layer (1220) on the patterned photosensitive dielectric layer (1200); and
patterning the photoresist layer (1220), and removing a photoresist on the at least one groove (1222) of the photosensitive dielectric layer (1200);
the step of forming the at least one pad layer (1202) in the at least one groove (1222) comprises:
forming at least another one pad layer on the at least one pad layer (1202) in a groove which the photosensitive dielectric layer (1200) and the photoresist layer (1220) together form, wherein a top surface of the at least another one pad layer is higher than a top surface of the photosensitive dielectric layer (1200); and
the step of forming the at least one protective metal layer (1204) on the at least one pad layer (1202) comprises:
forming the at least one protective metal layer (1204) on the at least another one pad layer; and
removing the photoresist layer (1220).
